# EUROPEAN PATENT APPLICATION

(11) **EP 2 172 970 A1**
(43) Date of publication of application: **07.04.2010**
(21) Application number: 08703434.4
(22) Date of filing: 18.01.2008
(51) Int. Cl.: H01L 23/02, H01L 27/14

(54) **SEMICONDUCTOR PACKAGE AND ITS MANUFACTURING METHOD**

(30) Priority: 19.07.2007 JP 2007188241
(71) Applicant: Fujikura, Ltd., Tokyo 135-8512 (JP)
(72) Inventor: HIRAFUNE, Sayaka, Sakura-shi Chiba 285-8550 (JP); SUEMASU, Tatsuo, Sakura-shi Chiba 285-8550 (JP)
(74) Representative: Cabinet Plasseraud
(86) International application number: PCT/JP2008/050584
(87) International publication number: WO 2009/011140

(57) **Abstract**

A semiconductor package includes at least: a workpiece at least one surface of which is equipped with a device; a wall portion provided along an outer circumference of the device and is spaced apart from the device; and a cover member that is arranged above the device so as to form a first space and is supported by the workpiece via the wall portion, in which the first space includes at least one second space that communicates with an external space.

## Description

### TECHNICAL FIELD

The present invention relates to a semiconductor package and a manufacturing method for the same, and more particularly to a semiconductor package equipped with a cover member for protecting a device in which dew condensation is prevented from forming therein, and a manufacturing method for the same.
Priority is claimed on Japanese Patent Application No. 2007-188241, filed on July 19, 2007, the contents of which are incorporated herein by reference.

### BACKGROUND ART

In workpieces on which a device is formed, a package is often provided with a cover member for protecting the device. For example, in packaging a device equipped with an image sensor such as a CCD, a piece of cover glass as a protection member is sometimes provided via an adhesive layer so as to form a predetermined space in order to protect the microlens above the image area against a process environment or a use environment.

However, with such a package construction, the regions on the inner side and the outer side of the adhesive layer are not completely sealed from each other in the case where the adhesive layer is made of a resin.
Therefore, slight moisture or the like on the outer side sometimes finds its way into the space on the inner side through the adhesive layer made of a resin to cause dew condensation. This may lead to defect imagery. In addition, it is difficult to completely replace the atmosphere in a region (that is, a space) on the inner side of the adhesive layer with an inactive gas atmosphere. Hence, a slight amount of gas component produced during the process sometimes remains in the region on the inner side, leading to a cause of defect such as dew condensation.

Therefore, to prevent dew condensation from forming in a package, there is proposed a method of securing ventilation with an outside of a package for a semiconductor apparatus in which a reinforcing ring is arranged so as to surround a semiconductor element formed on an insulative substrate, a resin is injected between the semiconductor element and the insulative substrate, and a cap is mounted above the semiconductor element and on the reinforcing ring. The ventilation is secured by forming a vent into the reinforcing ring, or through an interface between the cap and the reinforcing ring, or between the insulative substrate and the reinforcing ring (see Patent Document 1).

However, in such a method, it is required to form a vent for ventilation with the outside of the package by providing a groove or the like in the cap, the reinforcing ring, or the insulative substrate. This is burdensome because the construction of the vent is complex, and also demands time and effort in manufacture. In addition, since a reinforcing ring is required, the size is fixed, and freedom in design is not obtained. Therefore, this has a disadvantage in making a package thin.
Patent Document 1: Japanese Unexamined Patent Application, First Publication No. H11-126835

### DISCLOSURE OF INVENTION

The present invention has been achieved in view of the above circumstances, and has an object to provide a semiconductor package provided with a construction simple and unlikely to allow dew condensation to form in the package.
Furthermore, the present invention has another object to provide a manufacturing method of a semiconductor package with reduced manufacturing time and effort for making dew condensation unlikely to form in the package.

A semiconductor package according to a first aspect of the present invention includes at least: a workpiece at least one surface of which is equipped with a device; a wall portion provided along an outer circumference of the device and is spaced apart from the device; and a cover member that is arranged above the device so as to form a first space and is supported by the workpiece via the wall portion, in which the first space includes at least one second space that communicates with an external space.

Furthermore, in the semiconductor package, the wall portion may be made of a resin, and form the second space.

Furthermore, in the semiconductor package, the second space may include a non-straight portion.

Furthermore, a manufacturing method of a semiconductor package according to a second aspect of the present invention is a manufacturing method of a semiconductor package that includes at least: a workpiece at least one surface of which is equipped with a device; a wall portion provided along an outer circumference of the device and is spaced apart from the device; and a cover member that is arranged above the device so as to form a first space and is supported by the workpiece via the wall portion, wherein the first space includes at least one second space that communicates with an external space, the method including: providing a wall portion along an outer circumference of a device with spaced apart from the device with which the workpiece is equipped; forming a second space through the wall portion, the second space communicating an inside region surrounded by the wall portion with an outside region thereof; and arranging a cover member above the workpiece, the cover member being supported via the wall portion so as to form a first space that communicates with an external space through the second space.

A semiconductor package according to the first aspect of the present invention includes at least one second space through which a first space communicates with an external space. The first space is formed by arranging a cover member so as to be supported by a workpiece via a wall portion that is provided in a spaced manner along an outer circumference of a device with which the workpiece is equipped. Consequently, with the second space, it is possible to offer a degree of freedom to the inflow and outflow of a gas or the like so as to prevent the gas or the like from remaining in the first space. Therefore, it is possible to provide a semiconductor package with a simple construction that prevents a gas or the like from remaining in the package and makes dew condensation unlikely to form.

In a manufacturing method of a semiconductor package according to the second aspect of the present invention, a wall portion is provided along an outer circumference of a device with which a workpiece is equipped.
The wall portion is formed being spaced apart from the device. Next, through the wall portion, there is formed a second space that communicates an inside region surrounded by the wall portion with an outside region thereof. Furthermore, above the workpiece, there is arranged a cover member that is supported via the wall portion so as to form a first space that communicates with an external space through the second space. Consequently, it is possible to very easily provide a second space that can offer a degree of freedom to the inflow and outflow of a gas or the like so as to prevent the gas or the like from remaining in the first space. Therefore, it is possible to manufacture a semiconductor package with reduced manufacturing time and effort in which dew condensation is unlikely to form in the package.

### BRIEF DESCRIPTION OF THE DRAWINGS

FIG. 1A is a cross-sectional view showing one example of a semiconductor package according to the present invention.
FIG. 1B is a plan view showing the example of a semiconductor package according to the present invention.
FIG. 2 is a diagram showing one example of a first process of manufacturing the semiconductor package shown in FIG. 1A and 1B.
FIG. 3 is a diagram showing one example of a second process of manufacturing the semiconductor package shown in FIG. 1A and 1B.
FIG. 4 is a diagram showing one example of a third process of manufacturing the semiconductor package shown in FIG. 1A and 1B.
FIG. 5 is a diagram showing one example of a fourth process of manufacturing the semiconductor package shown in FIG. 1A and 1B.
FIG. 6 is a diagram showing another example of a semiconductor package according to the present invention.
FIG. 7 is a diagram showing another example of a semiconductor package according to the present invention.
FIG. 8 is a diagram showing another example of a semiconductor package according to the present invention.

### DESCRIPTION OF THE REFERENCE SYMBOLS

10, 20, 30, 40: semiconductor package, 11: workpiece, 12: device, 13: wall portion, 14: cover member, 15: first space, 16, 26, 36, 46: second space

### BEST MODE FOR CARRYING OUT THE INVENTION

Hereunder is a description of the present invention with reference to the drawings, based on the best mode.

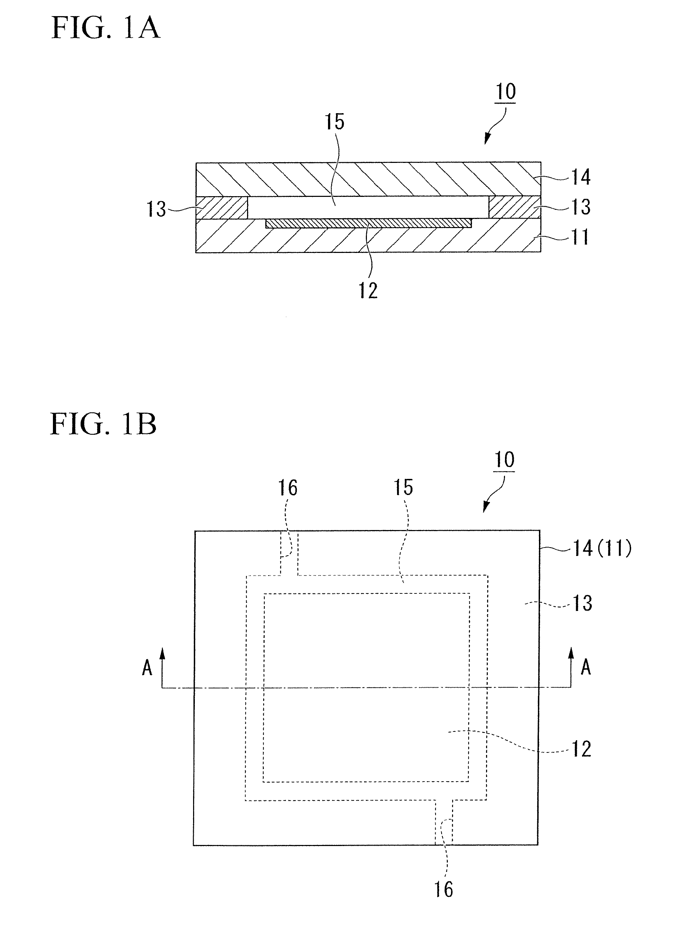

FIGS. 1A and 1B are respectively a cross-sectional view and a plan view schematically showing one example of a semiconductor package according to the present invention. FIG. 1A shows a cross-sectional view of the semiconductor package of FIG. 1B, taken along the A-A line. In the other embodiments that will be described later, constituent parts to those of the present embodiment are designated with same reference numerals and are not repetitiously explained. They are considered the same unless otherwise explained.

As shown in FIGS. 1A and 1B, a semiconductor package 10 in the present embodiment includes at least: a workpiece 11 at least one surface of which is equipped with a device 12; a cover member 14 arranged above the device 12; and a wall portion 13 that supports the cover member 14 above the workpiece 11.

The workpiece 11 is a base material at least one surface of which is equipped with a device 12. As the base material, for example a semiconductor wafer made from silicon (Si) or a substrate made of glass may be used. As the device 12, for example an image sensor such as a CCD may be used.

The wall portion 13 is made of a resin such as an epoxy resin, an acrylic resin, a silicone resin, or an epoxy acrylate resin. It is provided along an outer circumference of the device 12 to be protected and the wall portion 13 is spaced apart from the device 12. The wall portion 13 does not have a perfect ring shape. It includes at least one second space 16 that communicates an inside area surrounded by the wall portion 13 with an outside area thereof.
With the wall portion 13 made of a resin, the formation of the second space 16 is made easy. In addition, with the wall portion 13 made of a resin such as an adhesive, it is possible to easily adjust its height on the spot. Therefore, it is possible to make a package thin with a high degree of freedom in design.
As for a formation method of the wall portion 13, for example a photosensitive resin such as a UV-curing resin may be used to perform patterning. Alternatively, the wall portion 13 may be formed through printing or the like. In addition, a resin sheet with a uniform thickness may be affixed on the workpiece 11, and then a known photolithography technique may be used to perform a pattern formation (patterning), to thereby form the second space 16.

The second space 16 is a flow passage for providing design freedom to the inflow and outflow of a gas or the like which is a cause of dew condensation so that the gas never remains in the package (that is, an inside region surrounded by the wall portion 13, which region is to form a first space 15 (described later)). In the example illustrated in the figure, the second space 16 is made into a straight shape that is easy to form and likely to produce a flow of a gas or the like.
It is preferable that at least one second space 16 is provided. For example, it may be configured such that a partition is provided in a single second space 16, to thereby arrange an inlet and an outlet adjacently. Alternatively, it may be configured such that a second space 16 for an inlet and a second space 16 for an outlet may be provided. In the case of arranging more than one second space 16, it is desirable that the second spaces 16 be provided, for example, on the diagonal line(s) of the package so as to produce flows all over in the package with efficiency.

The cover member 14 is a member for protecting the device 12 provided on the workpiece 11. It is supported by the workpiece 11 via the wall portion 13, and is arranged above the device 12 so as to form a first space 15. That is, the first space 15 is a region surrounded by the workpiece 11, the wall portion 13, and the cover member 14. Therefore, the first space 15 includes the second space 16 that communicates with the external space, as described above. If the device 12 provided on the workpiece 11 is an image sensor, it is desirable that the cover member 14 be made of one that transmits light such as glass. Conversely, if the device 12 is one that requires light to be shielded, it is desirable that a material which does not transmit light be used therefor.
The semiconductor package 10 may be fabricated at wafer level. The wafer may be cut into chip sizes, to thereby obtain a plurality of semiconductor packages 10.

Next is a description of one example of a manufacturing method of a semiconductor package with a first construction in the present invention.

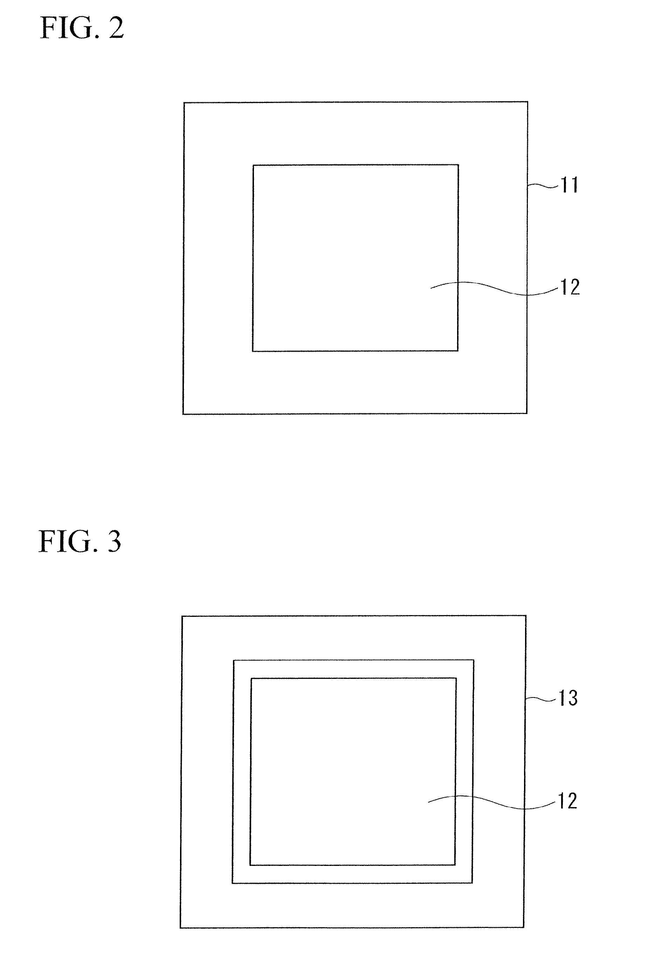

FIG. 2 to FIG. 5 are diagrams sequentially showing one example of the manufacturing process thereof.
First, as shown in FIG. 2, a workpiece 11 being 5 mm long × 5 mm wide × 0.2 mm thick is prepared. The workpiece 11 is equipped with a device 12 on at least one surface thereof.

Next, as shown in FIG. 3, a wall portion 13 with a height of 0.05 mm is provided along an outer circumference of the device 12 and being spaced apart from the device 12 with which the workpiece 11 is equipped. The wall portion 13 is made of a photosensitive epoxy resin, and formed by the spin coating method.

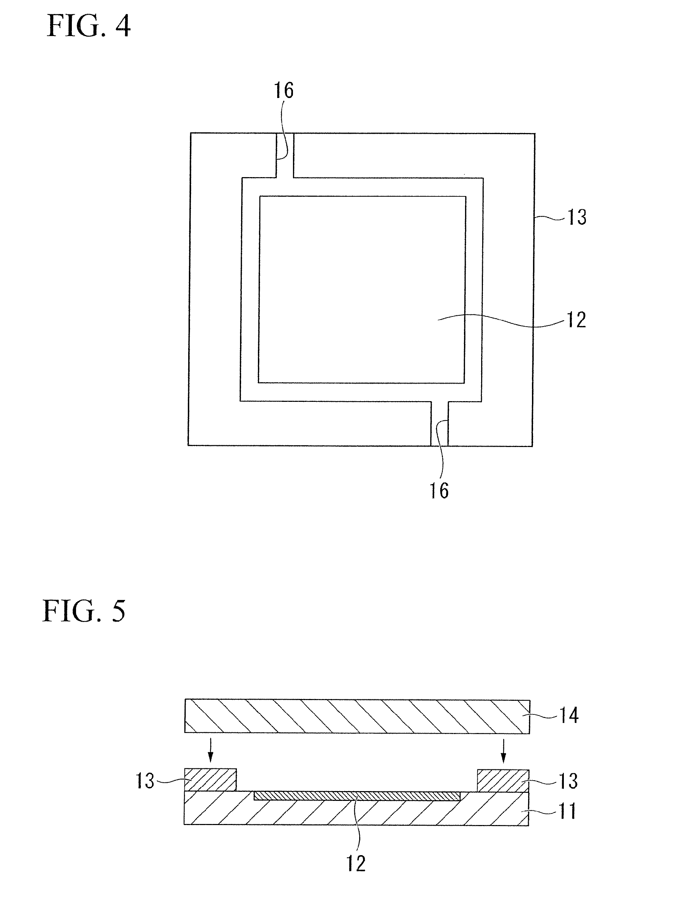

Furthermore, as shown in FIG. 4, second spaces 16 with a width of 0.05 mm, which communicate the inside region surrounded by the wall portion 13 with the outside region thereof, are formed through the wall portion 13. The second spaces 16 are formed by the photolithography method. As shown in the figure, the second spaces 16 are provided on a diagonal line in the package (two in total: one in upper left; and the other in lower right).

Then, as shown in FIG. 5, a cover member 14 supported via the wall portion 13 is arranged above the workpiece 11. Thereby, the semiconductor package 10 as shown in FIGS. 1A, 1B can be fabricated in which the first space 15 communicates with the external space through the second spaces 16.
In the present description, the wall portion 13 is formed on the workpiece 11. However, the present invention is not limited to this. The wall portion 13 may be formed on the cover member 14. In this case, after the formation of the wall portion 13, the cover member 14 may be coupled to the workpiece 11.

Therefore, in the semiconductor package 10 with the first construction, the second spaces prevent a gas or the like from remaining in the first space. This can eliminate, for example, a defect in which dew condensation is formed on the microlens of the CCD to prevent an image pickup, and can also eliminate the possibility of deterioration of a device due to dew condensation. In addition, the process for making dew condensation unlikely to form is simple, enabling improvement in production efficiency of the packages.

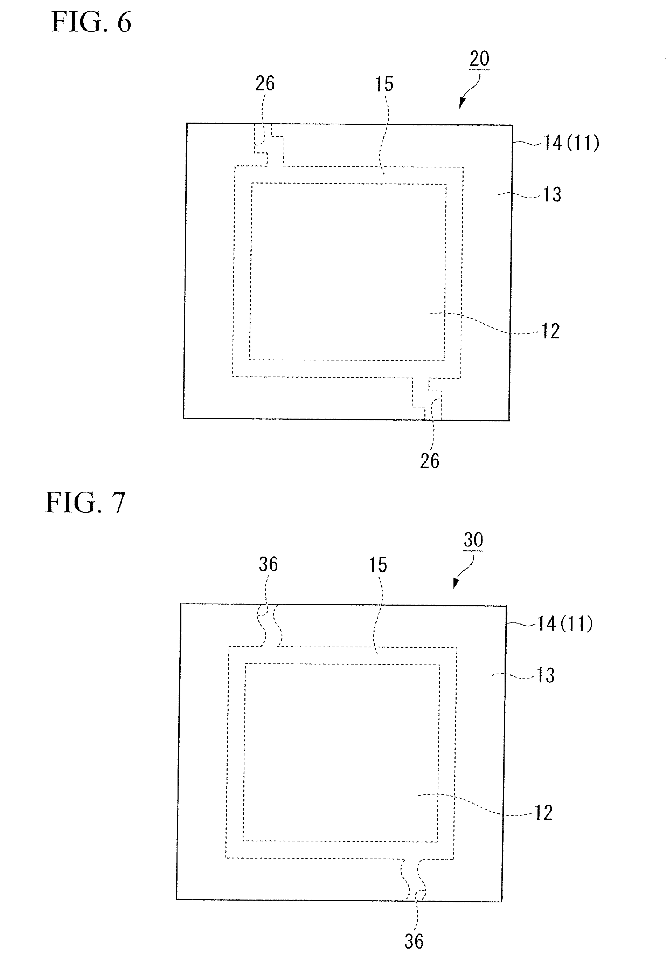

Furthermore, the present invention is not limited to the semiconductor package in which the second spaces are formed in a straight shape. The semiconductor package may have second spaces with a non-straight shape as shown in FIG. 6 and FIG. 7.
FIG. 6 is a plan view schematically showing a second construction of a semiconductor package according to the present invention.
A semiconductor package 20 in the present embodiment has, as shown in FIG. 6, a construction that includes at least: a workpiece 11 at least one surface of which is equipped with a device 12; a wall portion 13 provided in a spaced manner along an outer circumference of the device 12; and a cover member 14 that is arranged above the device 12 so as to form a first space 15 and is supported by the workpiece 11 via the wall portion 13, in which the first space 15 includes at least one second space 26 with a crank shape that communicates with an external space.
In the example shown in the figure, the second space 26 has a planar crank shape. However, the present invention is not limited to this. The second space 26 may have a sterically crank shape (in a height direction).

Thus, with the second space formed in a crank shape with a non-straight portion, foreign matter such as dust is required to move in a snaking manner to intrude into the first space 15 surrounded by the wall portion 13. This can further enhance the effect of preventing foreign matter or the like from going into the first space 15 during the process.

FIG. 7 is a plan view schematically showing a third construction of a semiconductor package according to the present invention.
A semiconductor package 30 in the present embodiment has, as shown in FIG. 7, a construction that includes at least: a workpiece 11 at least one surface of which is equipped with a device 12; a wall portion 13 provided along an outer circumference of the device 12 and the wall portion 13 is spaced apart from the device 12; and a cover member 14 that is arranged above the device 12 so as to form a first space 15 and is supported by the workpiece 11 via the wall portion 13, and further includes at least one second space 36 with a curved shape through which the first space 15 communicates with an external space.
In the example shown in the FIG. 7, the second space 36 has a planar curved shape. However, the present invention is not limited to this. The second space 36 may have a sterically curved shape (in a height direction).

Thus, with the second space formed in a curved shape with a non-straight portion, foreign matter such as dust is required to move in a snaking manner to intrude into the first space 15 surrounded by the wall portion 13 as described above. This can further enhance the effect of preventing foreign matter or the like during the process from going into the first space 15. In addition, with the non-straight portion, the flow of a gas or the like can be made less likely to be prevented.

Furthermore, the present invention may be a semiconductor package that includes, for a single second space, a plurality of opening portions that communicate with the external space and one or more opening portions that communicate with the first space.

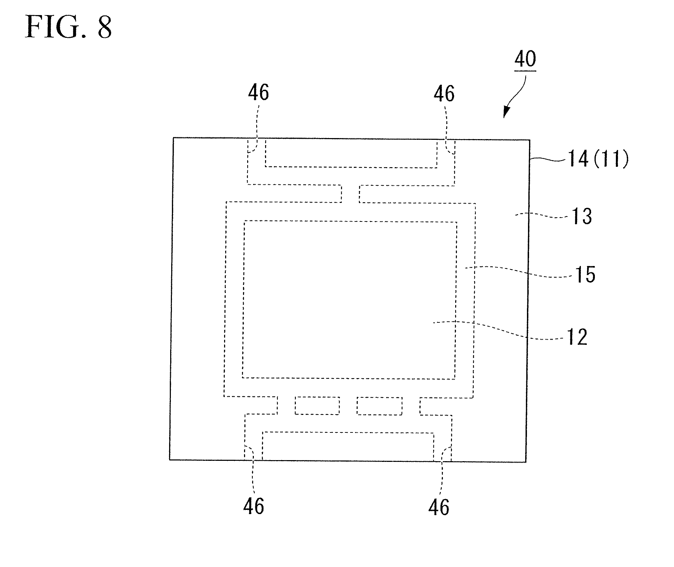

FIG. 8 is a plan view schematically showing a fourth construction of a semiconductor package according to the present invention.
A semiconductor package 40 in the present embodiment has, as shown in FIG. 8, a construction that includes at least: a workpiece 11 at least one surface of which is equipped with a device 12; a wall portion 13 provided along an outer circumference of the device 12 and the wall portion is spaced apart from the device 12; and a cover member 14 that is arranged above the device 12 so as to form a first space 15 and is supported by the workpiece 11 via the wall portion 13, in which second spaces 46 include one or more openings that communicate with the first space 15 and/or a plurality of openings that communicate with an external space.
In the example shown in the FIG. 8, the second space 46 has a planar straight shape. However, the present invention is not limited to this. The second space 46 may have a planar curved shape. Alternatively, the second space 46 may have a sterically straight or sterically curved shape (in a height direction).

Thus, with the second space 46 having one opening in communication with the first space 15 and two or more openings in communication with the external space that are likely to be influenced by particles or the like, even if a portion of the second space 46 is poorly fabricated or the second space 46 is influenced by particles or the like, the rest of the passages of the second space 46 function as a backup. Therefore, it is possible to obtain a semiconductor package 40 stable toward dew condensation or the like. Furthermore, with a plurality of crank portions, it is possible to more effectively suppress intrusion of particles or the like.
Conversely, it is also possible to provide second space 46 with more openings in communication with the first space 15. In this case, it is possible to obtain a second space 46 as a ventilation passage with higher circulation efficiency. Especially, by providing the sterically shaped second spaces 46, not planarly shaped second spaces, in the vicinity of the cover member 14 and the workpiece 11 respectively, it is possible to offer a function of cooling the device 12 in addition to that of preventing dew condensation on the cover member 14.

### INDUSTRIAL APPLICABILITY

The present invention is applicable to a semiconductor package equipped with a cover member for protecting a device.

## Claims

1. A semiconductor package, comprising at least:
a workpiece at least one surface of which is equipped with a device;
a wall portion provided along an outer circumference of the device and is spaced apart from the device; and
a cover member that is arranged above the device so as to form a first space and is supported by the workpiece via the wall portion, wherein
the first space comprises at least one second space that communicates with an external space.

2. The semiconductor package according to claim 1, wherein
the wall portion is made of a resin, and forms the second space.

3. The semiconductor package according to claim 1 or 2, wherein
the second space comprises a non-straight portion.

4. A manufacturing method of a semiconductor package that comprises at least: a workpiece at least one surface of which is equipped with a device; a wall portion provided along an outer circumference of the device and is spaced apart from the device; and a cover member that is arranged above the device so as to form a first space and is supported by the workpiece via the wall portion, wherein the first space comprises at least one second space that communicates with an external space, the method comprising:
providing a wall portion along an outer circumference of a device with spaced apart from the device with which the workpiece is equipped;
forming a second space through the wall portion, the second space communicating an inside region surrounded by the wall portion with an outside region thereof; and
arranging a cover member above the workpiece, the cover member being supported via the wall portion so as to form a first space that communicates with an external space through the second space.

5. The manufacturing method of a semiconductor package according to claim 4, wherein
the semiconductor package is fabricated at wafer level.
